(19) Europäisches Patentamt
European Patent Office
Office européen des brevets

(11) **EP 4 435 869 A1**

(12) **EUROPEAN PATENT APPLICATION**

(43) Date of publication:
**25.09.2024 Bulletin 2024/39**

(21) Application number: **23195660.8**

(22) Date of filing: **06.09.2023**

(51) International Patent Classification (IPC):
**H01L 29/16** (2006.01)     **H01L 29/32** (2006.01)
**H01L 21/329** (2006.01)     **H01L 29/861** (2006.01)
**H01L 29/78** (2006.01)

(52) Cooperative Patent Classification (CPC):
**H01L 29/861; H01L 29/1608; H01L 29/32;
H01L 29/6606**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **22.03.2023   JP 2023045991**

(71) Applicants:
• **Kabushiki Kaisha Toshiba
Minato-ku
Tokyo (JP)**

• **Toshiba Electronic Devices & Storage
Corporation
Tokyo (JP)**

(72) Inventor: **SUZUKI, Takuma
Hyogo (JP)**

(74) Representative: **Kramer Barske Schmidtchen
Patentanwälte PartG mbB
European Patent Attorneys
Landsberger Strasse 300
80687 München (DE)**

(54) **SEMICONDUCTOR DEVICE**

(57)     The embodiment is a semiconductor device containing silicon carbide. The semiconductor device (1) includes a semiconductor substrate (10), a first semiconductor portion (20), a second semiconductor portion (30), a third semiconductor portion (40), and a fourth semiconductor portion (50). Each of the first semiconductor portion to the third semiconductor portion contains impurities having a first conductivity type, and the fourth semiconductor portion contains impurities having a second conductivity type. A carrier concentration of the second semiconductor portion is the same as or lower than a carrier concentration of the first semiconductor portion. The carrier concentration of the second semiconductor portion is the same as or higher than a carrier concentration of the third semiconductor portion. A point defect density of the second semiconductor portion is the same as or higher than a point defect density of the first semiconductor portion, and is higher than a point defect density of the third semiconductor portion.

FIG. 1

EP 4 435 869 A1

## Description

FIELD

Embodiments relate to a semiconductor device.

BACKGROUND

For example, there is a semiconductor device using a substrate containing silicon carbide (SiC). It is desired that the semiconductor device has stable characteristics.

BRIEF DESCRIPTION OF THE DRAWINGS

FIG. 1 is a schematic cross-sectional view illustrating a semiconductor device according to a first embodiment;

FIG. 2 to FIG. 4 are schematic cross-sectional views illustrating a part of a method for manufacturing the semiconductor device according to the first embodiment;

FIG. 5 and FIG. 6 are schematic cross-sectional views illustrating a part of a variation of the method for manufacturing the semiconductor device according to the first embodiment;

FIG. 7 and FIG. 8 are schematic cross-sectional views illustrating a part of another variation of the method for manufacturing the semiconductor device according to the first embodiment;

FIG. 9 is a schematic cross-sectional view for describing an operation of the semiconductor device according to the first embodiment;

FIG. 10 is a schematic cross-sectional view for describing an operation of a semiconductor device of a comparative example;

FIG. 11 is a schematic cross-sectional view illustrating a semiconductor device according to a variation of the first embodiment;

FIG. 12 and FIG. 13 are schematic cross-sectional views illustrating a part of a method for manufacturing the semiconductor device according to the variation of the first embodiment;

FIG. 14 and FIG. 15 are schematic cross-sectional views illustrating a part of a variation of the method for manufacturing the semiconductor device according to the variation of the first embodiment;

FIG. 16 is a schematic cross-sectional view illustrating a semiconductor device according to another variation of the first embodiment;

FIG. 17 to FIG. 19 are schematic cross-sectional views illustrating a part of a method for manufacturing the semiconductor device according to the other variation of the first embodiment;

FIG. 20 is a schematic cross-sectional view illustrating a semiconductor device according to a second embodiment.

FIG. 21 is a schematic cross-sectional view taken along a line B-B in FIG. 20;

FIG. 22 is a schematic enlarged view of a portion C in FIG. 20;

FIG. 23 and FIG. 24 are schematic cross-sectional views illustrating a part of a method for manufacturing the semiconductor device according to the second embodiment;

FIG. 25 is a schematic cross-sectional view describing an operation of the semiconductor device according to the second embodiment;

FIG. 26 is a schematic cross-sectional view taken along a line D-D in FIG. 25;

FIG. 27 is a schematic cross-sectional view describing an operation of a semiconductor device according to a comparative example;

FIG. 28 is a schematic cross-sectional view taken along a line E-E in FIG. 27;

FIG. 29 is a schematic cross-sectional view illustrating a semiconductor device according to a variation of the second embodiment;

FIG. 30 is a schematic enlarged view of a portion F in FIG. 29;

FIG. 31 and FIG. 32 are schematic cross-sectional views illustrating a part of a method for manufacturing the semiconductor device according to the variation of the second embodiment;

FIG. 33 is a schematic cross-sectional view illustrating a semiconductor device according to another variation of the second embodiment;

FIG. 34 is a schematic enlarged view of a portion G in FIG. 33;

FIG. 35 and FIG. 36 are schematic cross-sectional views illustrating a part of a method for manufacturing the semiconductor device according to another variation of the second embodiment;

FIG. 37 is a schematic cross-sectional view illustrating a semiconductor device according to a third embodiment;

FIG. 38 is a schematic cross-sectional view taken along a line H-H in FIG. 37;

FIG. 39 is a schematic cross-sectional view for describing an operation of the semiconductor device according to the third embodiment;

FIG. 40 is a schematic cross-sectional view taken along a line I-I in FIG. 39;

FIG. 41 is a schematic cross-sectional view for describing an operation of a semiconductor device according to a comparative example; and

FIG. 42 is a schematic cross-sectional view taken along a line J-J in FIG. 41.

DETAILED DESCRIPTION

A semiconductor device according to the embodiment includes: a semiconductor substrate of a first conductivity type, the semiconductor substrate containing silicon carbide and having a first face and a second face opposite to the first face; a first semiconductor portion of the first conductivity type, the first semiconductor portion being provided on the first face and containing silicon carbide; a second semiconductor portion of the first conductivity type, the second semiconductor portion being provided on the first semiconductor portion and containing silicon carbide; a third semiconductor portion of the first conductivity type, the third semiconductor portion being provided on the second semiconductor portion and containing silicon carbide; and a fourth semiconductor portion of a second conductivity type, the fourth semiconductor portion being provided on the third semiconductor portion and containing silicon carbide. A carrier concentration of the first conductivity type in the second semiconductor portion is the same as or lower than a carrier concentration of the first conductivity type in the first semiconductor portion. The carrier concentration of the first conductivity type in the second semiconductor portion is the same as or higher than a carrier concentration of the first conductivity type in the third semiconductor portion. A point defect density in the second semiconductor portion is the same as or higher than a point defect density in the first semiconductor portion, and is higher than a point defect density in the third semiconductor portion.

Embodiments will now be described with reference to the drawings. The same portions inside the drawings are marked with the same numerals; a detailed description is omitted as appropriate; and the different portions are described. The drawings are schematic or conceptual; and the relationships between the thicknesses and widths of portions, the proportions of sizes between portions, etc., are not necessarily the same as the actual values thereof. The dimensions and/or the proportions may be illustrated differently between the drawings, even in the case where the same portion is illustrated.

In the following description and drawings, $n^+$, $n^-$, $p^+$, and p show relative levels of impurity concentrations. That is, a notation with "+" shows a relatively higher impurity concentration than a notation with neither "+" nor "-", and a notation with "-" shows a relatively lower impurity concentration than a notation with neither "+" nor "-". In the case where both a p-type impurity and an n-type impurity are contained in each region, these notations show relatively high and low net impurity concentrations after the impurities compensate for each other. The carrier concentration is regarded as an effective impurity concentration.

Each embodiment described below may be implemented by inverting a p type and an n type of each semiconductor region.

(First Embodiment)

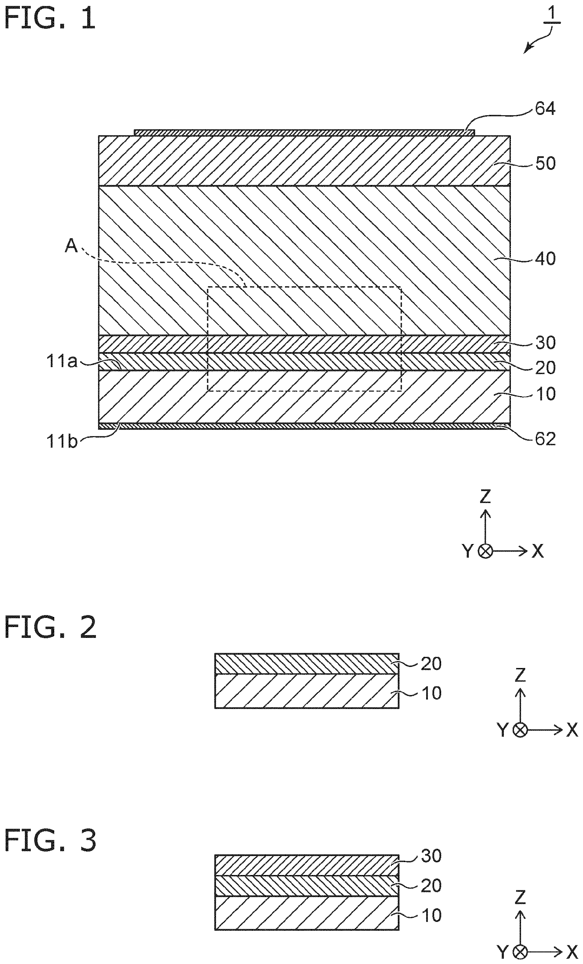

FIG. 1 is a schematic cross-sectional view illustrating a semiconductor device according to a first embodiment.

As shown in FIG. 1, a semiconductor device 1 according to the embodiment includes a semiconductor substrate 10, a first semiconductor layer (a first semiconductor portion) 20, a second semiconductor layer (a second semiconductor portion) 30, and a third semiconductor layer (a third semiconductor portion) 40. The semiconductor device 1 further includes a fourth semiconductor layer (a fourth semiconductor portion) 50, a first electrode 62, and a second electrode 64.

The first semiconductor layer 20 is provided on the semiconductor substrate 10. The second semiconductor layer 30 is provided on the first semiconductor layer 20. The third semiconductor layer 40 is provided on the second semiconductor layer 30. The fourth semiconductor layer 50 is provided on the third semiconductor layer 40. The first electrode 62 is provided on a face of the semiconductor substrate 10 opposite to a face on which the first semiconductor layer 20 is disposed. The second electrode 64 is provided on a face of the fourth semiconductor layer 50 opposite to a face on which the third semiconductor layer 40 is disposed.

The semiconductor substrate 10, the first semiconductor layer 20, the second semiconductor layer 30, the third semiconductor layer 40, and the fourth semiconductor layer 50 contain silicon carbide (SiC).

The semiconductor substrate 10, the first semiconductor layer 20, the second semiconductor layer 30, and the third semiconductor layer 40 are of a first conductivity type. The fourth semiconductor layer 50 is of a second conductivity type. For example, the first conductivity type is n type, and the second conductivity type is p type.

An impurity concentration in the first semiconductor layer 20 is higher than an impurity concentration in the third semiconductor layer 40. An impurity concentration in the second semiconductor layer 30 is the same as or higher than the impurity concentration in the third semiconductor layer 40. The impurity concentration in the second semiconductor layer 30 is the same as or lower than the impurity concentration in the first semiconductor layer 20. The semiconductor device 1 is, for example, a PiN diode.

The semiconductor substrate 10 has a first face 11a and a second face 11b. The second face 11b is a face opposite to the first face 11a. The first semiconductor layer 20 is provided on the first face 11a, and the first electrode 62 is provided on the second face 11b. The semiconductor substrate 10 is, for example, a SiC bulk single crystal substrate.

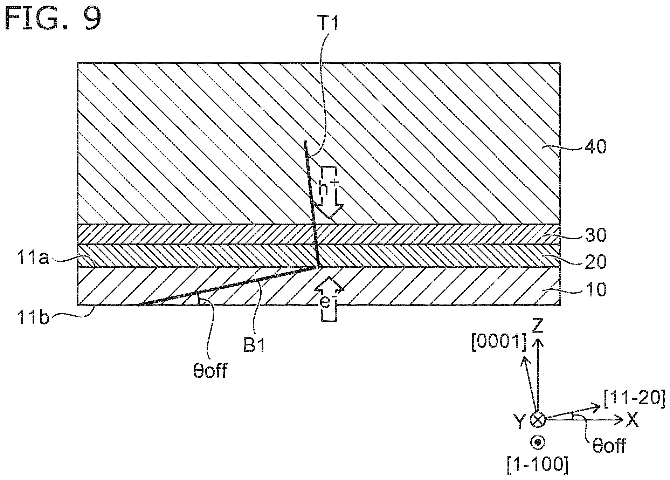

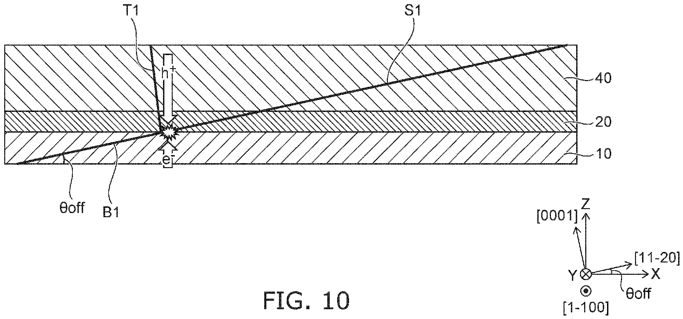

Hereinafter, an XYZ three-dimensional orthogonal coordinate system may be used for description. An XY plane is a plane parallel to the first face 11a or the second face 11b. A Z axis is orthogonal to the XY plane. As described with reference to FIG. 9, an X axis is inclined with respect to a [11-20] axis orthogonal to an {11-20} plane of the semiconductor substrate 10. The [11-20] axis is inclined by an off angle θoff with respect to the X axis. As for the definition of the angle, a counterclockwise rotation is positive with respect to a reference axis. A Y axis is parallel to a [1-100] axis orthogonal to a {1-100} plane of the semiconductor substrate 10. The Z axis is inclined with respect to a [0001] axis orthogonal to a {0001} plane of the semiconductor substrate 10. The [0001] axis is inclined by the off angle θoff with respect to the Z axis. That is, the {0001} plane is inclined by the off angle θoff with respect to the XY plane about the Y axis or the [1-100] axis. As shown in FIG. 9, a coordinate axis for a crystal axis may be written together with an XYZ coordinate axis. In this case, the [1-100] axis overlapping the Y axis is displayed below the Y axis. The same applies to FIG. 10, FIG. 20, FIG. 25, FIG. 27, FIG. 39, and FIG. 41. As described above, the [1-100] axis is parallel to the Y axis and has positive and negative directions opposite to those of the Y axis.

The first semiconductor layer 20 contains, for example, SiC and nitrogen (N) as an impurity. For example, phosphorus (P) may be contained instead of N, or both N and P may be contained. For example, an impurity concentration of N in the first semiconductor layer 20 is lower than $10^{-19}$ [cm$^{-3}$]. The first semiconductor layer 20 forms a point defect serving as a recombination center by appropriately setting the impurity concentration, shortens a recombination time of minority carriers injected from the fourth semiconductor layer 50, and prevents intrusion of the minority carriers, thereby reducing a generation amount of recombination energy. The first semiconductor layer 20 converts a basal plane dislocation (BPD) generated in the semiconductor substrate 10 into a threading edge dislocation (TED). The first semiconductor layer 20 prevents the BPD from expanding to a single shockley stacking fault (1SSF) by converting the BPD into the TED.

The second semiconductor layer 30 contains a first element as an impurity. The first element includes at least one selected from the group containing of N, P, aluminum (Al), and boron (B). The second semiconductor layer 30 may contain a second element instead of the first element. The second element includes at least one selected from the group containing of iron (Fe), nickel (Ni), chromium (Cr), magnesium (Mg), zinc (Zn), copper (Cu), calcium (Ca), vanadium (V), gold (Au), and platinum (Pt). The second semiconductor layer 30 may contain the first element and the second element.

The first semiconductor layer 20 and the second semiconductor layer 30 have point defect densities higher than point defect densities of the semiconductor substrate 10 and the third semiconductor layer 40. The second semiconductor layer 30 has a point defect density the same as or higher than a point defect density of the first semiconductor layer 20.

Since the second semiconductor layer 30 has a point defect density higher than point defect densities of the semiconductor substrate 10, the first semiconductor layer 20, and the third semiconductor layer 40, recombination of the minority carriers injected from the fourth semiconductor layer 50 is promoted, a lifetime of the minority carriers is shortened, and generation of recombination energy due to the recombination of the minority carriers is prevented. The second semiconductor layer 30 prevents the BPD from expanding to the 1SSF by preventing the generation of recombination energy.

When the semiconductor device 1 performs a forward direction operation of a diode, first conductivity type majority carriers travel through the third semiconductor layer 40 to cause a forward current to flow. When the semiconductor device 1 serves as a diode and performs a reverse blocking operation, the third semiconductor layer 40 forms a depletion layer to implement a desired breakdown voltage between the second electrode 64 as an anode electrode and the first electrode 62 as a cathode electrode.

The fourth semiconductor layer 50 is joined to the third semiconductor layer 40 to implement a p-n junction. When the semiconductor device 1 performs the forward direction operation of a diode, second conductivity type majority carriers travel through the fourth semiconductor layer 50 to cause a forward current to flow. When the semiconductor device 1 serves as a diode and performs a reverse blocking operation, the third semiconductor layer 40 and the fourth semiconductor layer 50 implement a desired breakdown voltage between the second electrode 64 as an anode electrode and the first electrode 62 as a cathode electrode.

The first electrode 62 is ohmically coupled to the semiconductor substrate 10 and functions as one main electrode of the semiconductor device 1. The second electrode 64 is ohmically coupled to the fourth semiconductor layer 50, and functions as the other main electrode of the semiconductor device 1. When the semiconductor device 1 is a diode, the first electrode 62 is a cathode electrode, and the second electrode 64 is an anode electrode.

A method for manufacturing the semiconductor device 1 according to the embodiment will be described.

FIG. 2 to FIG. 4 are schematic cross-sectional views illustrating a part of the method for manufacturing the semiconductor device according to the first embodiment.

FIG. 2 to FIG. 4 show a cross section of a portion corresponding to a portion A in FIG. 1. In the embodiment, when a cross section of the semiconductor device is shown, it is assumed that the cross section corresponds to the portion A in FIG. 1 even in other drawings, unless otherwise specified.

As shown in FIG. 2, the first semiconductor layer 20 is formed on the prepared semiconductor substrate 10. The first semiconductor layer 20 is formed by epitaxial growth.

As shown in FIG. 3, the second semiconductor layer 30 is formed on the first semiconductor layer 20. The second semiconductor layer 30 is formed by epitaxial growth. When the second semiconductor layer 30 is epitaxially grown, the first element (N, P, Al, and B) is doped to form a recombination center for Auger recombination.

After the second semiconductor layer 30 is formed by epitaxial growth, the second element (Fe, Ni, Cr, Mg, Zn, Cu, Ca, V, Au, and Pt) may be introduced into the second semiconductor layer 30 by thermal diffusion. When the second element is introduced instead of the first element, the second element is suitable to form a point defect serving as a recombination center without increasing the impurity concentration in the second semiconductor layer 30.

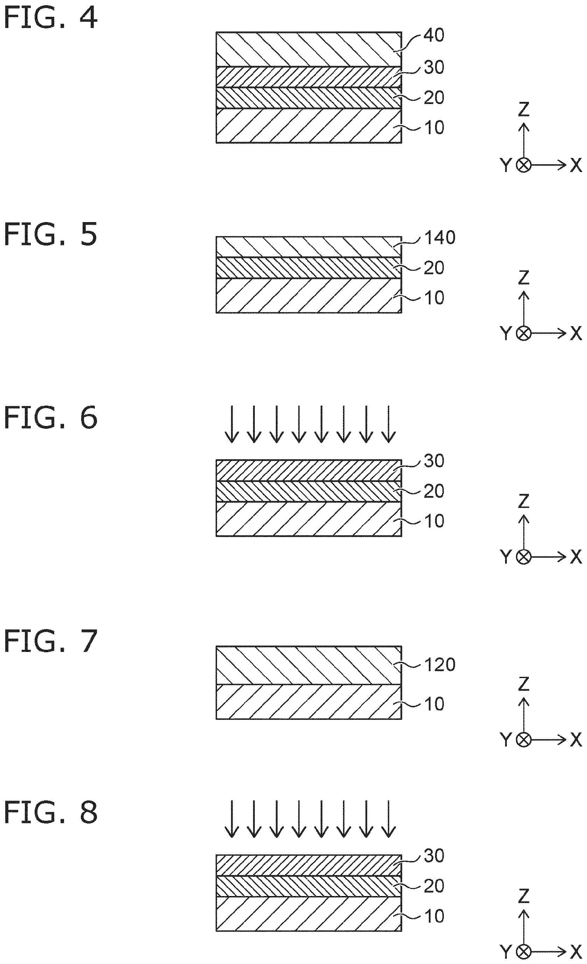

As shown in FIG. 4, the third semiconductor layer 40 is formed on the second semiconductor layer 30. The third semiconductor layer 40 is formed by epitaxial growth.

Thereafter, the fourth semiconductor layer 50 is formed on the third semiconductor layer 40, and the first electrode 62 and the second electrode 64 are formed, thereby forming the semiconductor device 1.

FIG. 5 and FIG. 6 are schematic cross-sectional views illustrating a part of a variation of the method for manufacturing the semiconductor device according to the first embodiment.

As shown in FIG. 5, the first semiconductor layer 20 is formed on the prepared semiconductor substrate 10 as described with reference to FIG. 2, and an intermediate semiconductor layer 140 is formed on the first semiconductor layer 20 by epitaxial growth. For example, an impurity concentration of the intermediate semiconductor layer 140 is the same as that of the third semiconductor layer 40 shown in FIG. 1. That is, the impurity concentration of the intermediate semiconductor layer 140 is lower than the impurity concentration in the first semiconductor layer 20. For example, the intermediate semiconductor layer 140 is formed under conditions the same as those for the third semiconductor layer 40.

As shown in FIG. 6, the second semiconductor layer 30 is formed on the first semiconductor layer 20. The second semiconductor layer 30 is formed by ion-implanting a third element into the intermediate semiconductor layer 140 shown in FIG. 5. The third element includes at least one selected from the group containing of hydrogen (H), helium (He), argon (Ar), neon (Ne), and xenon (Xe). H introduced into the intermediate semiconductor layer 140 by ion implantation is introduced as protons. Ion implantation energy is set according to a thickness of the intermediate semiconductor layer 140. The third element is desorbed through a normal heating process after the process shown in FIG. 6. Therefore, by ion-implanting the third element into the intermediate semiconductor layer 140, the second semiconductor layer 30 having a high density of point defects can be formed without increasing an impurity concentration.

In the ion implantation into the intermediate semiconductor layer 140, the second element (Fe, Ni, Cr, Mg, Zn, Cu, Ca, V, Au, Pt) may be used instead of the third element. These elements form a deep level in a forbidden band of the intermediate semiconductor layer 140 and function as a recombination center, and thus the second semiconductor layer 30 having a high density of point defects can be formed without increasing the impurity concentration.

FIG. 7 and FIG. 8 are schematic cross-sectional views illustrating a part of another variation of the method for manufacturing the semiconductor device according to the first embodiment.

As shown in FIG. 7, an intermediate semiconductor layer 120 is formed on the prepared semiconductor substrate 10 by epitaxial growth. The intermediate semiconductor layer 120 in this case is formed to be thicker than the first semiconductor layer 20 described with reference to FIG. 2. The intermediate semiconductor layer 120 has a thickness obtained by adding a thickness of the second semiconductor layer 30 to a thickness of the first semiconductor layer 20.

As shown in FIG. 8, the third element is ion-implanted into the intermediate semiconductor layer 120 to form the second semiconductor layer 30. The second semiconductor layer 30 can be formed on the first semiconductor layer 20 by adjusting the ion implantation energy. In the ion implantation into the second semiconductor layer 30, the second element may be used instead of the third element. In any case, the second semiconductor layer 30 having a point defect density higher than the point defect density of the first semiconductor layer 20 can be formed without increasing the impurity concentration of the second semiconductor layer 30 to be higher than the impurity concentration of the first semiconductor layer 20.

An operation and effects of the semiconductor device 1 according to the embodiment will be described.

FIG. 9 is a schematic cross-sectional view for describing an operation of the semiconductor device according to the first embodiment.

FIG. 9 shows a crystal axis of SiC together with an XYZ coordinate system. The [11-20] axis is inclined in a positive direction by the off angle θoff with respect to the X axis about the Y axis and the [1-100] axis. The [0001] axis is inclined by the off angle θoff with respect to the Z axis about the Y axis and the [1-100] axis. That is, the {0001} plane of SiC forming the semiconductor substrate 10, the first semiconductor layer 20, the second semiconductor layer 30, and the third semiconductor layer 40 is inclined by the off angle θoff with respect to the XY plane about the Y axis and the [1-100] axis. The off angle θoff is, for example, appropriately 4°.

As shown in FIG. 9, holes $h^+$, which are minority carriers injected from the fourth semiconductor layer 50 shown in FIG. 1, are injected into the second semiconductor layer 30 via the third semiconductor layer 40. In the second semiconductor layer 30, point defects formed at a high density function as recombination centers of the minority carriers, and recombine and annihilate the holes $h^+$ and electrons $e^-$ in a short lifetime. Therefore, in the second semiconductor layer 30, the BPD that obtains the recombination energy of the minority carriers is prevented from expanding to the 1SSF.

For example, a dislocation B1 which is the BPD in the semiconductor substrate 10 can be formed along the {0001} plane of SiC. That is, the dislocation B1 is formed at the off angle θoff with respect to the XY plane. When the dislocation B1 reaches the first semiconductor layer 20, the dislocation B1 is converted into a dislocation T1 which is the TED in the first semiconductor layer 20.

The dislocation T1 is formed along a [0001]-axis direction. The holes $h^+$ traveling in the third semiconductor layer 40 travel substantially along a Z-axis direction. Since the Z axis and the [0001] axis form an off angle θoff of appropriately 4°, the dislocation T1 does not hinder the traveling of the holes $h^+$. Therefore, by converting the dislocation B1 into the dislocation T1 in the first semiconductor layer 20, the resistance of the semiconductor device 1 during conduction is not increased.

The minority carriers passing through the third semiconductor layer 40 are rapidly recombined at the recombination center of the second semiconductor layer 30, and thus the minority carriers hardly supply recombination energy to the dislocation B1 formed in the semiconductor substrate 10. Even when a small portion of the minority carriers pass through the second semiconductor layer 30, the minority carriers are rapidly recombined at the recombination center of the first semiconductor layer 20, and thus the dislocation B1 is prevented from expanding to the 1SSF.

FIG. 10 is a schematic cross-sectional view illustrating a semiconductor device according to a comparative example.

In the semiconductor device according to the comparative example in FIG. 10, the second semiconductor layer 30 shown in FIG. 9 is not provided on the first semiconductor layer 20, and the third semiconductor layer 40 is provided directly on the first semiconductor layer 20.

As shown in FIG. 10, in the semiconductor device of the comparative example, the dislocation B1 not converted into the dislocation T1 in the second semiconductor layer 30 obtains recombination energy between the holes $h^+$ and the electrons $e^-$, and is expanded to a defect S1 which is the 1SSF. The defect S1 is expanded in the third semiconductor layer 40 along the [11-20] axis toward a positive direction of the Z axis as long as the recombination energy is supplied. The defect S1 inhibits carrier travelling, and thus a forward voltage with respect to a forward current in the semiconductor device 1 increases, which may lead to an increase in loss.

Conventionally, there has been a phenomenon in which a BPD obtains recombination energy due to recombination of holes and electrons and is expanded to a 1SSF. In order to promote recombination between holes and electrons and to prevent expansion from the BPD to the 1SSF, a recombination promoting buffer layer into which nitrogen is introduced at a high concentration is provided (for example, Patent Literature 1). In such a technique, by increasing a concentration of nitrogen introduced into the recombination promoting buffer layer, the point defect density is improved, and the recombination of the holes and the electrons is promoted. On the other hand, it is known that when nitrogen is introduced at a concentration exceeding $10^{-19}$ [cm$^{-3}$], the quality of epitaxial crystal of a low-concentration drift layer adjacent to the recombination promoting buffer layer is adversely affected.

The semiconductor device 1 according to the embodiment includes the second semiconductor layer 30 having an impurity concentration lower than the impurity concentration in the first semiconductor layer 20 corresponding to the recombination promoting buffer layer and having a point defect density higher than the point defect density of the first semiconductor layer 20. The third semiconductor layer 40 corresponding to the low-concentration drift layer is coupled to the first semiconductor layer 20 and the semiconductor substrate 10 through the second semiconductor layer 30.

The second semiconductor layer 30 has an impurity concentration the same as or lower than the first semiconductor layer 20, and has a point defect density the same as or higher than the first semiconductor layer 20. Therefore, the influence on the crystal quality of the third semiconductor layer 40 is prevented due to the low impurity concentration, and the recombination between the holes and the electrons is promoted due to the high point defect density, and thus the recombination energy is prevented from reaching the BPD. Therefore, by providing the second semiconductor layer 30, the BPD can be prevented from expanding to the 1SSF. Even when the BPD is expanded to the 1SSF, the recombination energy is not supplied to the 1SSF expanded from the BPD in the first semiconductor layer 20 since the second semiconductor layer 30 is provided between the third semiconductor layer 40 and the first semiconductor layer 20. Therefore, the 1SSF can be prevented from further expanding above the second semiconductor layer 30.

The point defects of the second semiconductor layer 30 are formed by introducing the first element (N, P, Al, and B) into the second semiconductor layer 30, or are implemented by introducing the second element (Fe, Ni, Cr, Mg, Zn, Cu, Ca, V, Au, and Pt) into the second semiconductor layer 30. Since the second element functions as a recombination center but does not function as an impurity, the second semiconductor layer 30 can implement a point defect density higher than the point defect density of the first semiconductor layer 20 at an impurity concentration lower than the impurity concentration in the first semiconductor layer 20.

The formation of point defects in the second semiconductor layer 30 can also be implemented by introducing a third element (H, He, Ar, Ne, and Xe) in addition to the above. After the third element is introduced into the second semiconductor layer 30, the third element itself disappears through a normal heating process of the semiconductor device 1. Therefore, the third element forms point defects but does not function as an impurity, and thus the second semiconductor layer 30 can implement a high point defect density with a low impurity concentration.

(Variation 1)

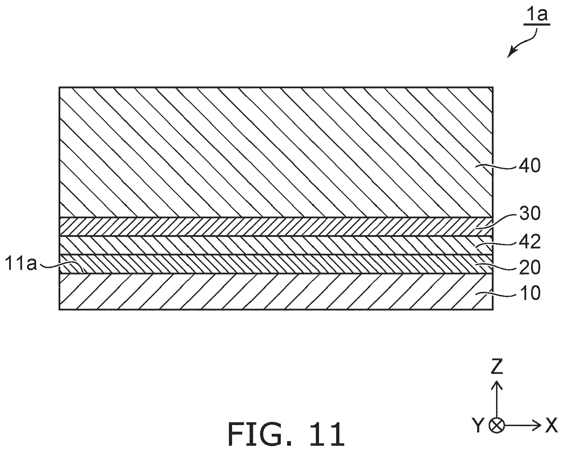

FIG. 11 is a schematic cross-sectional view illustrating a semiconductor device 1a according to a variation of the first embodiment.

As shown in FIG. 11, the semiconductor device 1a is different from the semiconductor device 1 shown in FIG. 1 in that a fifth semiconductor layer 42 is further provided. The other points are the same as those of the semiconductor device 1, the same components are denoted by the same reference numerals, and detailed description thereof is omitted.

The fifth semiconductor layer (fifth semiconductor portion) 42 is provided between the first semiconductor layer 20 and the second semiconductor layer 30. A first conductivity type impurity concentration in the fifth semiconductor layer 42 is substantially the same as an impurity concentration in the third semiconductor layer 40. A point defect density of the fifth semiconductor layer 42 is substantially the same as a point defect density of the third semiconductor layer 40. That is, an impurity concentration in the second semiconductor layer 30 is substantially the same as or higher than the impurity concentration in the fifth semiconductor layer 42. A point defect density of the second semiconductor layer 30 is higher than the point defect density of the fifth semiconductor layer 42. The point defect density of the second semiconductor layer 30 is favorably the same as or higher than a point defect density of the first semiconductor layer 20.

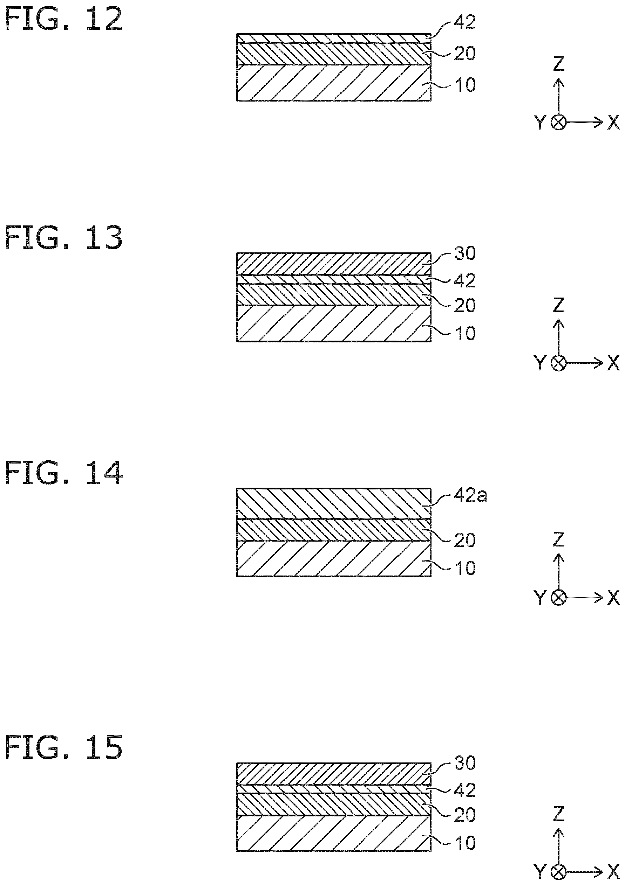

FIG. 12 and FIG. 13 are schematic cross-sectional views illustrating a part of a method for manufacturing the semiconductor device according to the variation of the first embodiment.

As shown in above FIG. 2, the first semiconductor layer 20 is formed on the prepared semiconductor substrate 10 by epitaxial growth. As shown in FIG. 12, the fifth semiconductor layer 42 is formed on the first semiconductor layer 20 by epitaxial growth. For example, the fifth semiconductor layer 42 is formed to have an impurity concentration substantially the same as that of the third semiconductor layer 40. For example, the fifth semiconductor layer 42 is formed under conditions the same as those for the third semiconductor layer 40.

As shown in FIG. 13, the second semiconductor layer 30 is formed on the fifth semiconductor layer 42. The second semiconductor layer 30 is formed by epitaxial growth. As described with reference to FIG. 3, the first element (N, P, Al, and B) is doped in the formation of the second semiconductor layer 30. Further, the second element (Fe, Ni, Cr, Mg, Zn, Cu, Ca, V, Au, and Pt) may be thermally diffused to form a point defect as a recombination center.

Thereafter, the third semiconductor layer 40, the fourth semiconductor layer 50, and the first electrode 62 are formed on the second semiconductor layer 30, and the second electrode 64 is formed on the semiconductor substrate 10, thereby forming the semiconductor device 1a.

FIG. 14 and FIG. 15 are schematic cross-sectional views illustrating a part of a variation of the method for manufacturing the semiconductor device according to the variation of the first embodiment.

As shown in FIG. 14, an intermediate semiconductor layer 42a is formed on the first semiconductor layer 20 by epitaxial growth. For example, formation conditions of the intermediate semiconductor layer 42a are the same as formation conditions for the third semiconductor layer 40. The intermediate semiconductor layer 42a to be formed has a thickness obtained by adding a thickness of the fifth semiconductor layer 42 and a thickness of the second semiconductor layer 30.

As shown in FIG. 15, the second semiconductor layer 30 is formed on the intermediate semiconductor layer 42a shown in FIG. 14 by ion implantation. As described with reference to FIG. 6, the second semiconductor layer 30 is formed by implanting the third element (H, He, Ar, Ne, and Xe) into the intermediate semiconductor layer 42a. By the introduction of the third element, a point defect is formed as a recombination center in the second semiconductor layer 30. The second element (Fe, Ni, Cr, Mg, Zn, Cu, Ca, V, Au, and Pt) may be ion-implanted instead of the third element.

Thereafter, the third semiconductor layer 40, the fourth semiconductor layer 50, and the first electrode 62 are formed on the second semiconductor layer 30, and the second electrode 64 is formed on the semiconductor substrate 10, thereby forming the semiconductor device 1a.

(Variation 2)

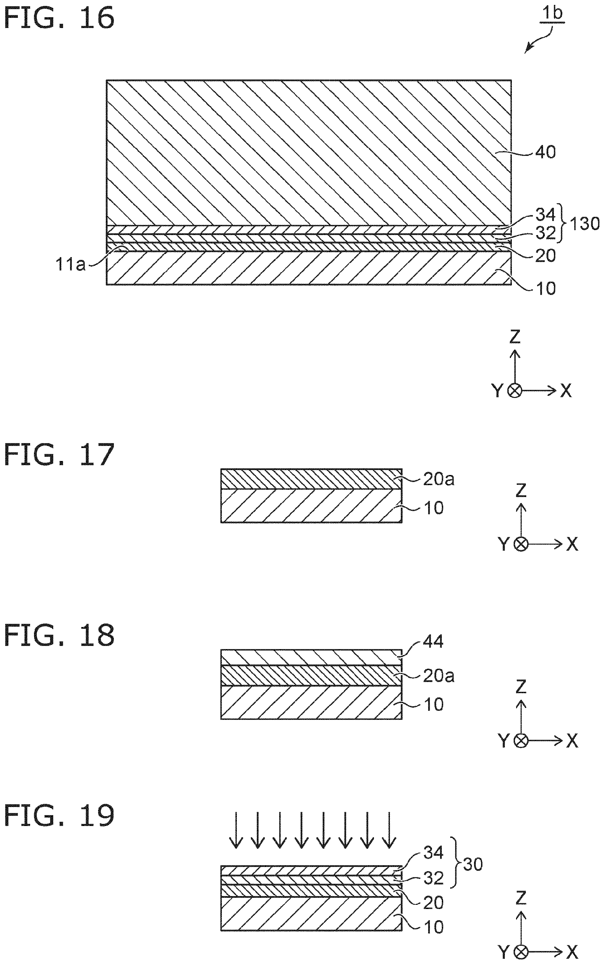

FIG. 16 is a schematic cross-sectional view illustrating a semiconductor device according to another variation of the first embodiment.

As shown in FIG. 16, a semiconductor device 1b according to the variation includes a second semiconductor layer 130 instead of the second semiconductor layer 30 shown in FIG. 1. Other components of the semiconductor device 1b are the same as those of the semiconductor device 1, the same components are denoted by the same reference numerals, and detailed description thereof is omitted.

The second semiconductor layer 130 is provided on the first semiconductor layer 20. The third semiconductor layer 40 is provided on the second semiconductor layer 130. The second semiconductor layer 130 includes a first layer 32 and a second layer 34. The first layer 32 is provided on the first semiconductor layer 20. The second layer 34 is provided on the first layer 32. The third semiconductor layer 40 is provided on the second layer 34.

The first layer 32 and the second layer 34 are both of a first conductivity type. An impurity concentration in the first layer 32 is the same as or higher than an impurity concentration in the second layer 34. The impurity concentration in the first layer 32 is the same as or higher than an impurity concentration in the first semiconductor layer 20. The impurity concentration in the second layer 34 is the same as or higher than an impurity concentration in the third semiconductor layer 40. The impurity concentration in the second layer 34 is the same as or lower than the impurity concentration in the first semiconductor layer 20.

A point defect density of the first layer 32 and a point defect density of the second layer 34 are substantially the same, and are the same as or higher than a point defect density of the first semiconductor layer 20.

A method for manufacturing the semiconductor device 1b according to the variation will be described.

FIG. 17 to FIG. 19 are schematic cross-sectional views illustrating a part of the method for manufacturing the semiconductor device according to the other variation of the first embodiment.

As shown in FIG. 17, a first intermediate semiconductor layer 20a is formed on the prepared semiconductor substrate 10. The first intermediate semiconductor layer 20a is formed to have a thickness obtained by adding a thickness of the first layer 32 of the second semiconductor layer 30 to a thickness of the first semiconductor layer 20.

As shown in FIG. 18, a second intermediate semiconductor layer 44 is formed on the first intermediate semiconductor layer 20a by epitaxial growth.

As shown in FIG. 19, the third element (proton, He, Ar, Ne, and Xe) is introduced into the first intermediate semiconductor layer 20a and the second intermediate semiconductor layer 44 by ion implantation. Energy during ion implantation is set so as to correspond to the thickness of the second semiconductor layer 30 among the thicknesses of the first intermediate semiconductor layer 20a and the second intermediate semiconductor layer 44.

Thereafter, the third semiconductor layer 40, the fourth semiconductor layer 50, and the first electrode 62 are formed on the second semiconductor layer 30, and the second electrode 64 is formed on the semiconductor substrate 10, thereby forming the semiconductor device 1a.

In this way, the semiconductor devices 1a and 1b according to the variations are formed. The semiconductor devices 1a and 1b according to the variations have the same effect as the semiconductor device 1 shown in FIG. 1.

(Second Embodiment)

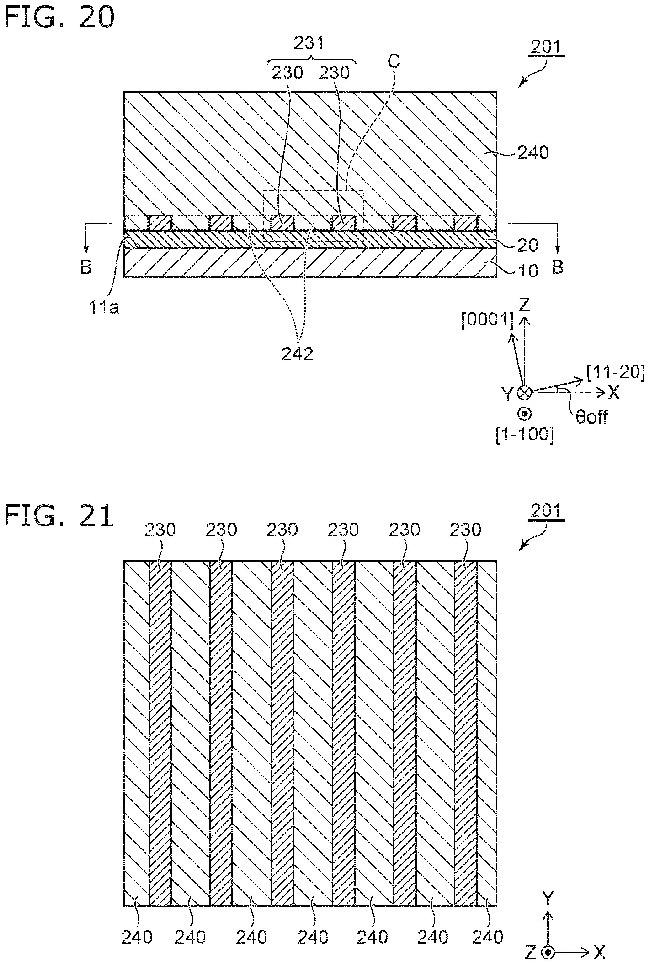

FIG. 20 is a schematic cross-sectional view illustrating a semiconductor device according to a second embodiment.

FIG. 21 is a schematic cross-sectional view taken along a line B-B in FIG. 20.

As shown in FIG. 20 and FIG. 21, a semiconductor device 201 according to the embodiment includes the semiconductor substrate 10, the first semiconductor layer 20, a second semiconductor layer (the second semiconductor portion) 231 including multiple first semiconductor regions (multiple first portions) 230, and a sixth semiconductor layer (the third semiconductor portion) 240. The semiconductor device 201 is different from the semiconductor device 1 shown in FIG. 1 in the multiple first semiconductor regions 230 and the sixth semiconductor layer 240, and is the same as the semiconductor device 1 in other points. The same components are denoted by the same reference numerals, and detailed description thereof is appropriately omitted.

The multiple first semiconductor regions 230 are provided on the first semiconductor layer 20. The multiple first semiconductor regions 230 each extend in a Y-axis direction on the first semiconductor layer 20. The multiple first semiconductor regions 230 are disposed apart from each other in an X-axis direction. In this example, the multiple first semiconductor regions 230 are disposed at substantially equal intervals in the X-axis direction.

As described with reference to FIG. 1, the XY plane is parallel to the first face 11a or the second face 11b of the semiconductor substrate 10, and the [11-20] axis of the semiconductor substrate 10 is inclined by the off angle $\theta$off with respect to the X axis about the Y axis. The [0001] axis of the semiconductor substrate 10 is inclined by the off angle $\theta$off with respect to the Z axis about the Y axis. The Y axis is parallel to the [1-100] axis orthogonal to the {1-100} plane of the semiconductor substrate 10. That is, the multiple first semiconductor regions 230 each extend along the [1-100] axis of the semiconductor substrate 10. The multiple first semiconductor regions 230 are disposed apart from each other at substantially equal intervals with respect to the [11-20] axis of the semiconductor substrate 10.

The sixth semiconductor layer 240 is provided on the multiple first semiconductor regions 230. The sixth semiconductor layer 240 includes a second semiconductor region (a second portion) 242. The second semiconductor region 242 is provided on the first semiconductor layer 20 between two adjacent first semiconductor regions 230 among the multiple first semiconductor regions 230. Multiple second semiconductor regions 242 are each provided between the multiple first semiconductor regions 230.

The semiconductor substrate 10, the first semiconductor layer 20, the multiple first semiconductor regions 230, the sixth semiconductor layer 240, and the multiple second semiconductor regions 242 contain first conductivity type impurities. The first conductivity type is, for example, n type.

Similar to the second semiconductor layer 30 of the semiconductor device 1 shown in FIG. 1, the first semiconductor region 230 contains SiC and the first element as an impurity. The first element includes at least one selected from the group containing of N, P, Al, and B. Similar to the semiconductor device 1, the first semiconductor region 230 may contain the second element instead of the first element or together with the first element. The second element includes at least one selected from the group containing of Fe, Ni, Cr, Mg, Zn, Cu, Ca, V, Au, and Pt.

An impurity concentration of the multiple first semiconductor regions 230 is the same as or lower than an impurity concentration in the first semiconductor layer 20. The impurity concentration of the multiple first semiconductor regions 230 is the same as or higher than an impurity concentration of the sixth semiconductor layer 240 and the second semiconductor region 242.

A point defect density of the multiple first semiconductor regions 230 is the same as or higher than a point defect density of the first semiconductor layer 20. The point defect density of the multiple first semiconductor regions 230 and the point defect density of the first semiconductor layer 20 are higher than both a point defect density of the semiconductor substrate 10 and a point defect density of the sixth semiconductor layer 240 and the second semiconductor region 242.

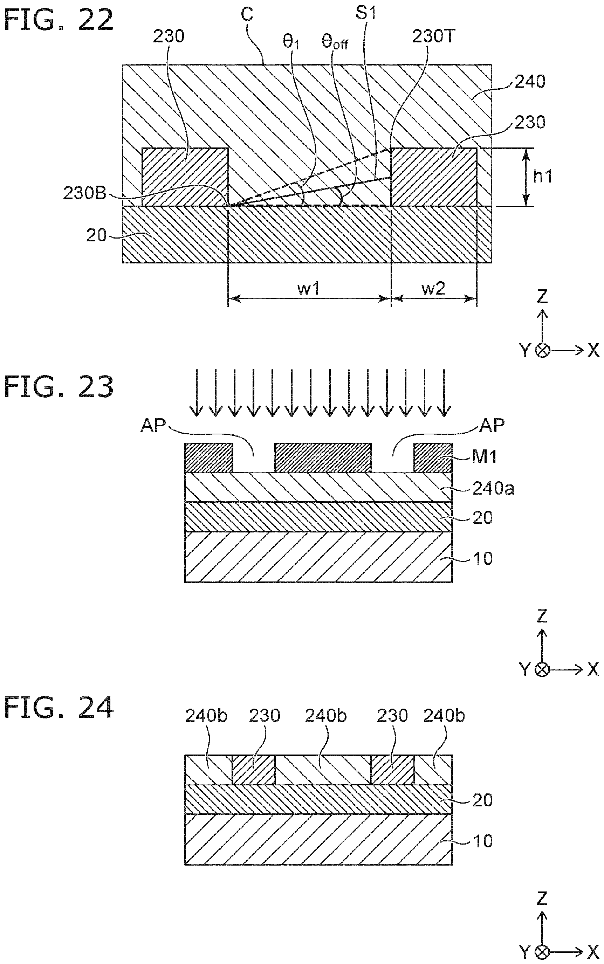

FIG. 22 is a schematic enlarged view of a portion C in FIG. 20.

FIG. 22 shows a relationship among distances W1 and W2 and a thickness h1.

The distance W1 shows a distance between two adjacent first semiconductor regions 230 among the multiple first semiconductor regions 230 in the X-axis direction. The distance W2 shows a width of each first semiconductor region 230 of the multiple first semiconductor regions 230. The thickness h1 shows a thickness of each first semiconductor region 230 of the multiple first semiconductor regions 230.

In FIG. 22, the distance W1 is a distance between lower ends 230B or upper ends 230T of two adjacent first semiconductor regions 230.

From the viewpoint of preventing a BPD from expanding to a 1SSF, it is favorable that W1 is small and W2 is large. The semiconductor device 1 described with reference to FIG. 1 is an example in the case of W1 = 0. The first semiconductor region 230 has a recombination center due to a point defect, and thus recombination of holes and electrons is promoted. On the other hand, the first semiconductor regions 230 are disposed in a current path, and a resistance value increases depending on the impurity concentration or the like of the first semiconductor regions 230, so that it is favorable to make W2 small.

The 1SSF expands along the {0001} plane of SiC inclined from the XY plane at the off angle $\theta$off. Therefore, from the viewpoint of preventing expansion of the 1SSF in the first semiconductor region 230, the relationship among W1, W2, and h1 is favorably set based on the off angle $\theta$off.

A relationship between W1 and h1 can be shown using an angle $\theta$1. W1 can be shown by the following equation (1).

$$W1 = h/\tan(\theta1) \quad (1)$$

A relationship between $\theta$1 in the equation (1) and the off angle $\theta$off can be set, for example, by the following equation (2).

$$2\theta\text{off} \geq \theta1 \geq 0.5\theta\text{off} \quad (2)$$

In the equation (2), a coefficient of $\theta$off is appropriately set according to manufacturing variations or the like during formation of the first semiconductor region 230.

A method for manufacturing the semiconductor device 201 according to the embodiment will be described.

FIG. 23 and FIG. 24 are schematic cross-sectional views illustrating a part of the method for manufacturing the semiconductor device according to the second embodiment.

As shown in FIG. 2, the first semiconductor layer 20 is formed on the prepared semiconductor substrate 10 by epitaxial growth. As shown in FIG. 23, an intermediate semiconductor layer 240a is formed on the first semiconductor layer 20. The intermediate semiconductor layer 240a is formed under conditions the same as those for the sixth semiconductor layer 240 shown in FIG. 20, for example. After the intermediate semiconductor layer 240a is formed, a mask M1 is formed on the intermediate semiconductor layer 240a. In the mask M1, an aperture AP is provided at a position where the first semiconductor region 230 is to be formed. Through the mask M1, the second element (Fe, Ni, Cr, Mg, Zn, Cu, Ca, V, Au, and Pt) or the third element (H, He, Ar, Ne, and Xe) is introduced into the intermediate semiconductor layer 240a by ion implantation.

As shown in FIG. 24, the mask M1 is removed. An intermediate semiconductor layer 240b is formed at a position where the mask M1 is provided, and the first semiconductor region 230 is formed at a position where the aperture AP of the mask M1 is provided.

Thereafter, a semiconductor layer is further formed on the first semiconductor region 230 and the intermediate semiconductor layer 240a by epitaxial growth to form the sixth semiconductor layer 240 shown in FIG. 20.

An operation and effects of the semiconductor device 201 according to the embodiment will be described.

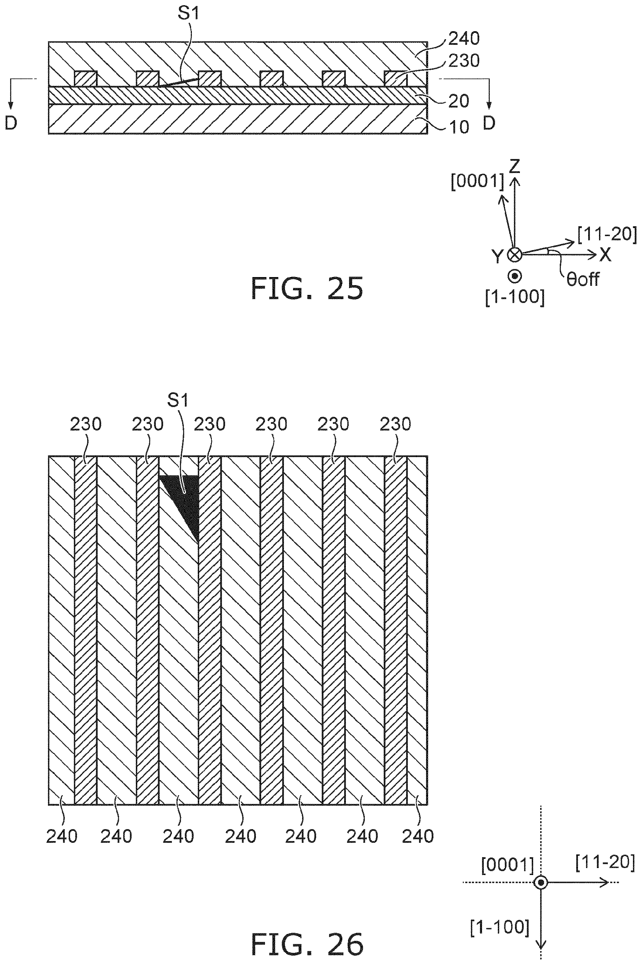

FIG. 25 is a schematic cross-sectional view describing an operation of the semiconductor device according to the second embodiment.

FIG. 26 is a schematic cross-sectional view taken along a line D-D in FIG. 25.

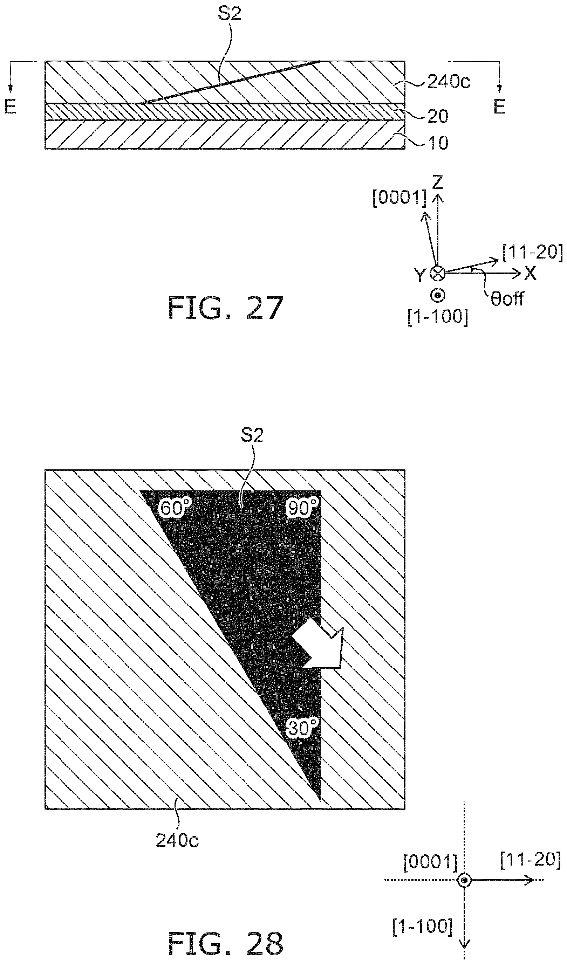

FIG. 25 shows a crystal axis of SiC together with the XYZ coordinate system. A relationship among the [11-20] axis, the [1-100] axis, and the [0001] axis is the same as that described with reference to FIG. 9. The same applies to FIG. 27, FIG. 28, and FIG. 39 to FIG. 42 to be described later.

FIG. 26 is shown as a cross-sectional view as viewed along the [0001] axis.

As shown in FIG. 25 and FIG. 26, in the semiconductor device 201 according to the embodiment, the sixth semiconductor layer 240 has a portion provided on the first semiconductor layer 20. In this portion, the BPD generated in the first semiconductor layer or the semiconductor substrate 10 can obtain recombination energy of minority carriers and expand to the defect S1 which is the 1SSF. The defect S1 expands upward at the off angle θoff with respect to the XY plane about the Y axis.

As shown in FIG. 26, the 1SSF expands in a triangular shape on a plane parallel to the {0001} plane of SiC, starting from the BPD. In the semiconductor device 201 according to the embodiment, a starting point of the defect S1 expanded to the 1SSF is in the sixth semiconductor layer 240, and the sixth semiconductor layer 240 has few point defects serving as recombination centers, and in the sixth semiconductor layer 240, minority carriers are continuously injected and recombination of the minority carriers continues. Therefore, the defect S1 obtains recombination energy and expands in the sixth semiconductor layer 240 between two adjacent first semiconductor regions 230.

In the first semiconductor region 230, a point defect functioning as the formed recombination center is formed with high density by the first element, the second element, or the third element. Therefore, in the first semiconductor region 230, a lifetime of the minority carriers is shortened, and intrusion of the minority carriers is prevented, thereby reducing recombination energy to be generated. When the defect S1 reaches the first semiconductor region 230, the defect S1 cannot receive the supply of the recombination energy, and the expansion stops.

Thus, the semiconductor device 201 with less conduction loss can be implemented.

FIG. 27 is a schematic cross-sectional view describing an operation of a semiconductor device according to a comparative example.

FIG. 28 is a schematic cross-sectional view taken along a line E-E in FIG. 27.

As shown in FIG. 27 and FIG. 28, in the semiconductor device according to the comparative example, the first semiconductor region 230 is not provided, and a sixth semiconductor layer 240c is provided on the first semiconductor layer 20.

In the semiconductor device of the comparative example, minority carriers supplied to the sixth semiconductor layer 240c are recombined in the sixth semiconductor layer 240c and continue to supply recombination energy to a defect S2 which is the 1SSF. As long as recombination energy is supplied, the defect S2 continues to spread in a planar shape having a triangular outer peripheral shape. The planar defect S2 spreads along the {0001} plane of SiC of the sixth semiconductor layer 240, and thus the defect S2 is formed substantially orthogonal to a current path. Therefore, current conduction of the semiconductor device is inhibited, and an operating voltage increases.

As described above, in the semiconductor device 201 according to the embodiment, the first semiconductor region 230 can stop the expansion of the 1SSF and prevent an increase in loss during conduction of the semiconductor device 201.

In the semiconductor device, forward conduction of a p-n junction can be implemented by travelling of the minority carriers. The first semiconductor region 230 can inhibit the travelling of the minority carriers by providing a high-density recombination center. Therefore, by disposing the multiple first semiconductor regions 230 at intervals, the expansion to the 1SSF starting from the BPD is restricted. By doing so, the formation of the 1SSF can be inhibited while the travelling of the minority carriers can be secured, and thus a semiconductor device with little conduction loss can be stably implemented.

As shown in FIG. 22, by appropriately setting the disposition interval and the thickness of the multiple first semiconductor regions 230, the semiconductor device 201 capable of reliably preventing the expansion of the 1SSF can be implemented.

(Variation 1)

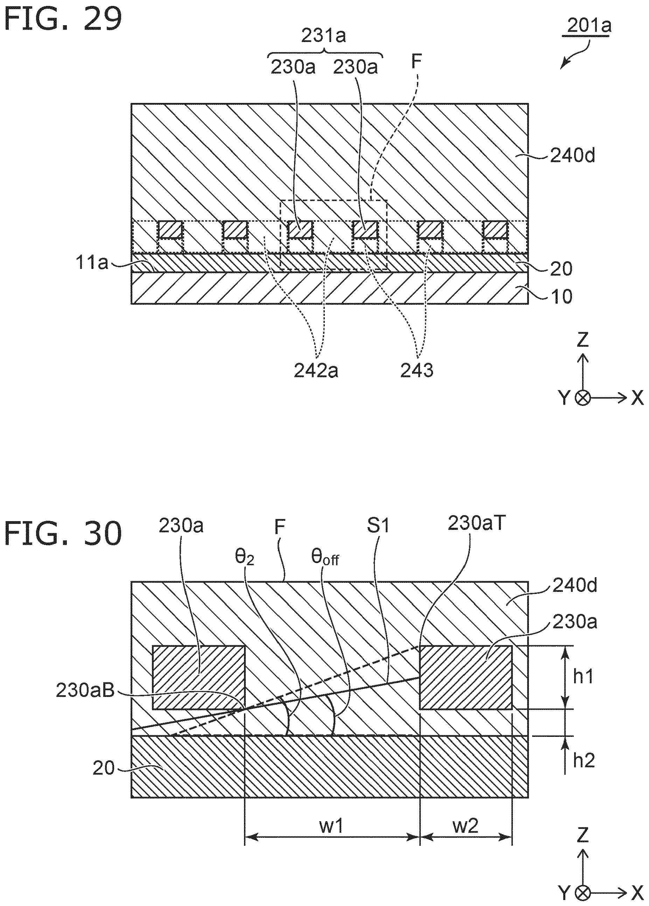

FIG. 29 is a schematic cross-sectional view illustrating a semiconductor device according to a variation of the second embodiment.

As shown in FIG. 29, a semiconductor device 201a according to the variation is different from the semiconductor device 201 shown in FIG. 20 in configurations of multiple first semiconductor regions (the multiple first portions) 230a and a sixth semiconductor layer (the third semiconductor portion) 240d. In other points, the semiconductor device 201a according to the variation is the same as the semiconductor device 201, the same components are denoted by the same reference numerals, and detailed description thereof is appropriately omitted.

A second semiconductor layer (the second semiconductor portion) 231a includes the multiple first semiconductor regions 230a. The multiple first semiconductor regions 230a are provided on the first semiconductor layer 20. As in the case of the multiple first semiconductor regions 230 of the semiconductor device 201 shown in FIG. 20 and FIG. 21, the multiple first semiconductor regions 230a each extend along the Y axis. As in the case of the multiple first semiconductor regions 230 of the semiconductor device 201, the multiple first semiconductor regions 230a are disposed apart from each other in the X-axis direction.

The sixth semiconductor layer 240d is provided on the multiple first semiconductor regions 230a. The sixth semiconductor layer 240d includes a third semiconductor region (a third portion) 243. The third semiconductor region 243 is provided between the first semiconductor layer 20 and each of the multiple first semiconductor regions 230a. That is, the first semiconductor region 230a is provided on the first semiconductor layer 20 with the third semiconductor region 243 interposed therebetween. As in the case of the sixth semiconductor layer 240 of the semiconductor device 201, the sixth semiconductor layer 240d includes a second semiconductor region (a second portion) 242a, and the second semiconductor region 242a is provided between adjacent first semiconductor regions 230a. The second semiconductor region 242a is also provided between adjacent third semiconductor regions 243.

Each of the multiple first semiconductor regions 230a contains the first element (N, P, Al, and B) or the second element as an impurity. An impurity concentration of the multiple first semiconductor regions 230a is the same as or lower than an impurity concentration in the first semiconductor layer 20. The impurity concentration of the multiple first semiconductor regions 230a is the same as or higher than an impurity concentration in the sixth semiconductor layer 240d, the second semiconductor region 242a, and the third semiconductor region 243.

A point defect density of the multiple first semiconductor regions 230a is the same as or higher than a point defect density of the first semiconductor layer 20. The point defect density of the multiple first semiconductor regions 230a and the point defect density of the first semiconductor layer 20 are higher than both a point defect density of the semiconductor substrate 10 and a point defect density of the sixth semiconductor layer 240d, the second semiconductor region 242a, and the third semiconductor region 243.

FIG. 30 is a schematic enlarged view of a portion F in FIG. 29.

FIG. 30 shows a relationship among the distances W1 and W2 and the thickness h1 for two adjacent first semiconductor regions 230a as in the case shown in FIG. 22. In FIG. 30, a thickness h2 shows a thickness of the sixth semiconductor layer 240d between the first semiconductor layer 20 and a lower end 230aB of the first semiconductor region 230a. Similar to the example shown in FIG. 22, the distance W1 is a distance between lower ends 230aB or between upper ends 230aT of two adjacent first semiconductor regions 230.

The 1SSF expands along the {0001} plane of SiC inclined from the XY plane at the off angle θoff. Therefore, from the viewpoint of preventing expansion of the 1SSF in the first semiconductor region 230a, the relationship among W1, W2, and h1 is favorably set based on the off angle θoff. As is clear from FIG. 30, the relationship between W1 and h1 in the example shown in FIG. 22 can also be shown in this example using an angle θ2. W1 is shown by the following equation (3), and a range of the angle θ2 can be set by an equation (4) in consideration of variations during manufacturing.

$$W1 = h/\tan(\theta 2) \quad (3)$$

$$2\theta off \geq \theta 2 \geq 0.5\theta off \quad (4)$$

A method for manufacturing the semiconductor device 201a according to the variation will be described.

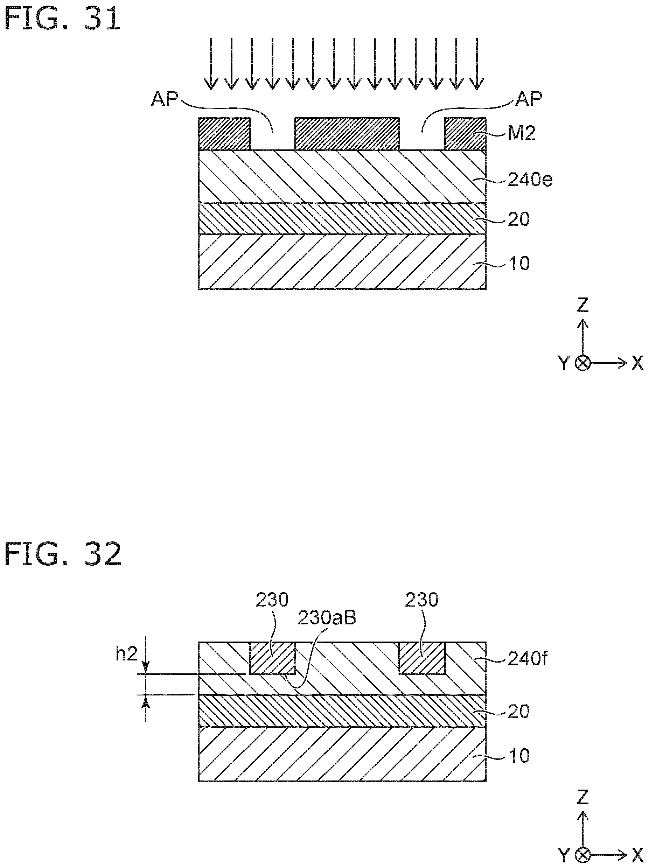

FIG. 31 and FIG. 32 are schematic cross-sectional views illustrating a part of the method for manufacturing the semiconductor device according to the variation of the second embodiment.

As shown in FIG. 2, the first semiconductor layer 20 is formed on the prepared semiconductor substrate 10 by epitaxial growth. As shown in FIG. 31, an intermediate semiconductor layer 240e is formed on the first semiconductor layer 20. The intermediate semiconductor layer 240e is formed under conditions the same as those for the sixth semiconductor layer 240 shown in FIG. 20, for example. After the intermediate semiconductor layer 240e is formed, a mask M2 is formed on the intermediate semiconductor layer 240e. In the mask M2, the aperture AP is provided at a position where the first semiconductor region 230a is to be formed. Through the mask M2, the second element (Fe, Ni, Cr, Mg, Zn, Cu, Ca, V, Au, and Pt) or the third element (H, He, Ar, Ne, and Xe) is introduced into the intermediate semiconductor layer 240a by ion implantation. Ion implantation energy is set such that the thickness h2 between the lower end 230aB of the first semiconductor region 230a and the first semiconductor layer 20 is obtained.

As shown in FIG. 32, the mask M2 is removed. An intermediate semiconductor layer 240f is formed at a position where the mask M2 is provided, and the first semiconductor region 230a is formed at a position where the aperture AP of the mask M2 is provided.

Thereafter, a semiconductor layer is further formed on the first semiconductor region 230a and the intermediate semiconductor layer 240f by epitaxial growth to form the sixth semiconductor layer 240d shown in FIG. 29.

(Variation 2)

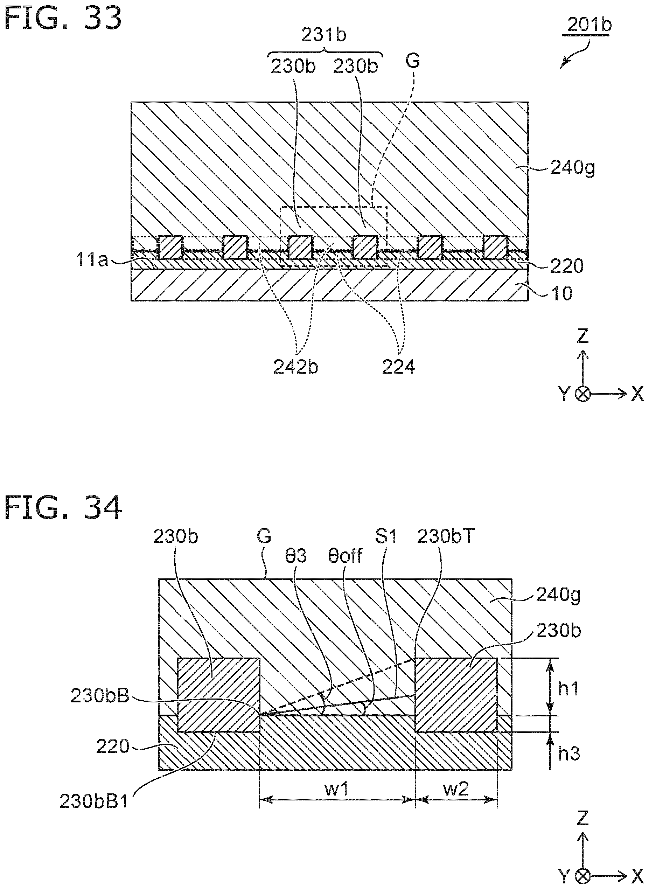

FIG. 33 is a schematic cross-sectional view illustrating a semiconductor device according to another variation of the second embodiment.

As shown in FIG. 33, the semiconductor device 201b according to the variation is different from the semiconductor device 201 shown in FIG. 20 in configurations of a first semiconductor layer (a first semiconductor portion) 220, multiple first semiconductor regions (the multiple first portions) 230b, and a sixth semiconductor layer (the third semiconductor portion) 240g. In other points, the semiconductor device 201b according to the variation is the same as the semiconductor device 201, the same components are denoted by the same reference numerals, and detailed description thereof is appropriately omitted.

The first semiconductor layer 220 is provided on the first face 11a of the semiconductor substrate 10. A second semiconductor layer (the second semiconductor portion) 231b includes the multiple first semiconductor regions 230b. The multiple first semiconductor regions 230b are provided on the first semiconductor layer 220. The first semiconductor layer 220 includes a fourth semiconductor region (a fourth portion) 224, and the fourth semiconductor region 224 is provided between adjacent first semiconductor regions 230b.

As in the case of the multiple first semiconductor regions 230 of the semiconductor device 201 shown in FIG. 20 and FIG. 21, the multiple first semiconductor regions 230b each extend along the Y axis. As in the case of the multiple first semiconductor regions 230 of the semiconductor device 201, the multiple first semiconductor regions 230b are disposed apart from each other in an X-axis direction.

The sixth semiconductor layer 240g is provided on the multiple first semiconductor regions 230b. As in the case of the sixth semiconductor layer 240 of the semiconductor device 201, the sixth semiconductor layer 240g includes a second semiconductor region (the second portion) 242b, and the second semiconductor region 242b is provided between adjacent first semiconductor regions 230b. The second semiconductor region 242b is provided on the fourth semiconductor region 224 between adjacent first semiconductor regions 230b.

An impurity concentration in the first semiconductor layer 220 and the fourth semiconductor region 224 is the same as an impurity concentration in the first semiconductor layer 20 of the semiconductor device 201 shown in FIG. 20. That is, the impurity concentration in the first semiconductor layer 220 and the fourth semiconductor region 224 is higher than an impurity concentration in the sixth semiconductor layer 240g and the second semiconductor region 242b.

Each of the multiple first semiconductor regions 230b contains the first element (N, P, Al, and B) or the second element (Fe, Ni, Cr, Mg, Zn, Cu, Ca, V, Au, and Pt) as an impurity. An impurity concentration in the multiple first semiconductor regions 230b is the same as or lower than the impurity concentration in the first semiconductor layer 220 and the fourth semiconductor region 224. The impurity concentration in the multiple first semiconductor regions 230b is the same as or higher than an impurity concentration in the sixth semiconductor layer 240g and the second semiconductor region 242b.

A point defect density of the multiple first semiconductor regions 230b is the same as or higher than a point defect density of the first semiconductor layer 220 and the fourth semiconductor region 224. The point defect density of the multiple first semiconductor regions 230b and the point defect density of the first semiconductor layer 220 and the fourth semiconductor region 224 are higher than both a point defect density of the semiconductor substrate 10 and a point defect density of the sixth semiconductor layer 240g and the second semiconductor region 242b.

FIG. 34 is a schematic enlarged view of a portion G in FIG. 23.

FIG. 34 shows a relationship among the distances W1, W2 and the thickness h1 for two adjacent first semiconductor regions 230b as in the case shown in FIG. 22. In FIG. 34, the thickness h1 is a length 230b to a boundary line 230bB with the first semiconductor layer 220 on a side surface of the first semiconductor region 230b from a bottom portion 230bB1 of the first semiconductor region 230b. A thickness h3 is a length from the bottom portion 230bB1 of the first semiconductor region 230b to the boundary line 230bB with the first semiconductor layer 220 on the side surface of the first semiconductor region 230b.

As in the case of the semiconductor device 201 shown in FIG. 20, from the viewpoint of preventing expansion of the 1SSF in the first semiconductor region 230b, a relationship among W1, W2, and h1 is favorably set based on the off angle θoff. As is clear from FIG. 34, the relationship between W1 and h1 in the example shown in FIG. 22 can also be shown in this example using an angle θ3. W1 is shown by the following equation (5), and a range of the angle θ2 can be set by an equation (6) in consideration of variations during manufacturing.

$$W1 = h/\tan(θ3) \quad (5)$$

$$2θoff ≥ θ3 ≥ 0.5θoff \quad (6)$$

A method for manufacturing the semiconductor device 201b according to the variation will be described.

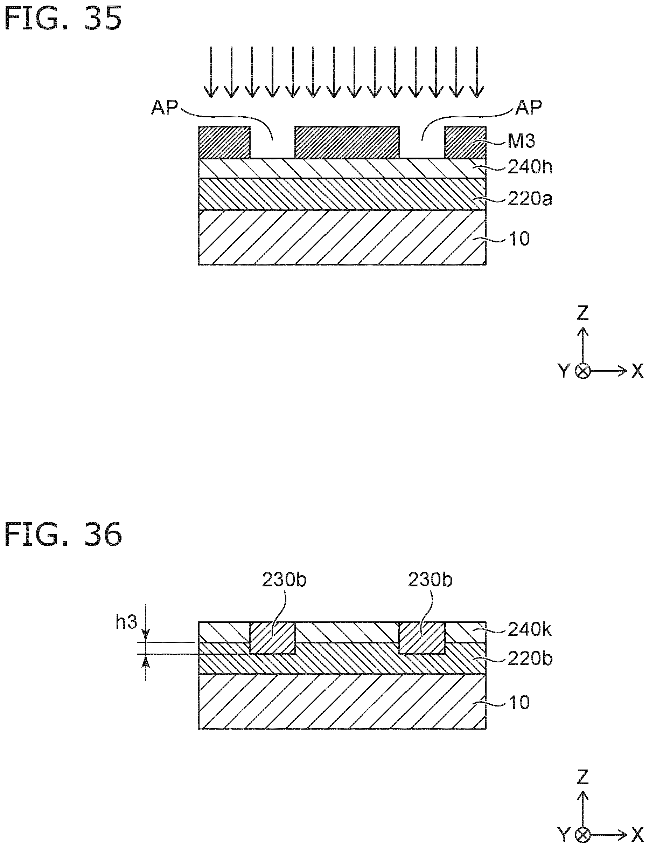

FIG. 35 and FIG. 36 are schematic cross-sectional views illustrating a part of the method for manufacturing the semiconductor device according to another variation of the second embodiment.

As shown in FIG. 35, a first semiconductor layer 220a is formed on the prepared semiconductor substrate 10 by epitaxial growth. An intermediate semiconductor layer 240h is formed on the first semiconductor layer 220a. The intermediate semiconductor layer 240h is formed under conditions the same as those for the sixth semiconductor layer shown in FIG. 20, for example. After the intermediate semiconductor layer 240h is formed, a mask M3 is formed on the intermediate semiconductor layer 240h. In the mask M3, the aperture AP is provided at a position where the first semiconductor region 230b is to be formed. Through the mask M3, the second element (Fe, Ni, Cr, Mg, Zn, Cu, Ca, V, Au, and Pt) or the third element (H, He, Ar, Ne, and Xe) is introduced into the intermediate semiconductor layer 240h by ion implantation. At this time, ion implantation energy is set so as to be is larger by the thickness h3 than a thickness of the intermediate semiconductor layer 240h.

As shown in FIG. 36, the mask M3 is removed.

An intermediate semiconductor layer 240k is formed at a position where the mask M3 is provided, and the first semiconductor region 230b is formed at a position where the aperture AP of the mask M3 is provided. The first semiconductor region 230b is formed in the intermediate semiconductor layer 240k. The first semiconductor region 230b penetrates the intermediate semiconductor layer 240k, and a portion of the first semiconductor region 230b is also formed in the first semiconductor layer 220b.

Thereafter, a semiconductor layer is further formed on the first semiconductor region 230b and the intermediate semiconductor layer 240k by epitaxial growth to form the sixth semiconductor layer 240g shown in FIG. 33.

In this way, the semiconductor devices 201a and 201b according to the variations are formed. The semiconductor devices 201a and 201b according to the variations have the same effect as the semiconductor device 201 shown in FIG. 20.

(Third Embodiment)

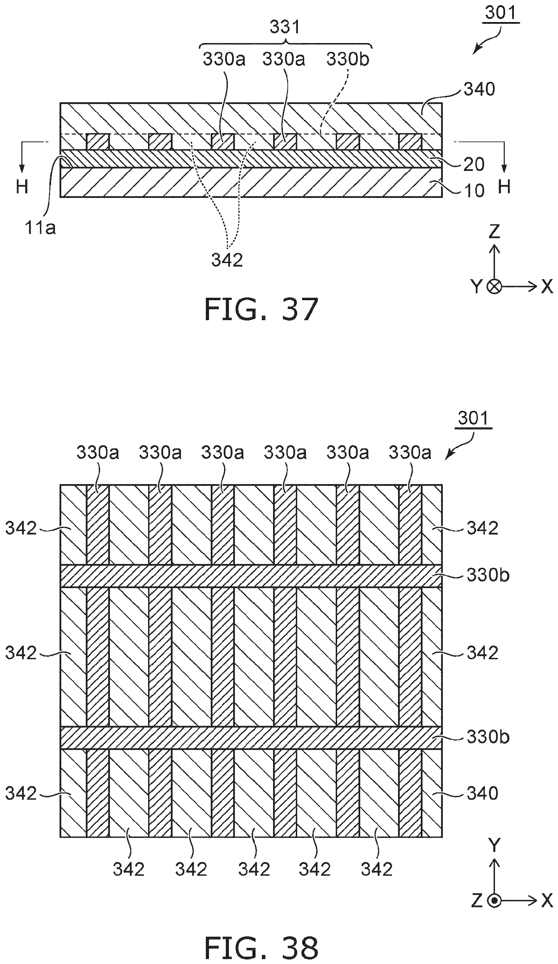

FIG. 37 is a schematic cross-sectional view illustrating a semiconductor device according to a third embodiment.

FIG. 38 is a schematic cross-sectional view taken along a line H-H in FIG. 37.

As shown in FIG. 37 and FIG. 38, a semiconductor device 301 according to the embodiment includes the semiconductor substrate 10, the first semiconductor layer 20, multiple first semiconductor regions (the multiple first portions) 330a, multiple fifth semiconductor regions (multiple fifth portions) 330b, and a sixth semiconductor layer (the third semiconductor portion) 340. The semiconductor device 301 is different from the semiconductor device 201 shown in FIG. 20 in configurations of the multiple first semiconductor regions 330a, the multiple fifth semiconductor regions 330b, and the sixth semiconductor layer 340, and is the same as the semiconductor device 201 in other points. The same components are denoted by the same reference numerals, and detailed description thereof is appropriately omitted.

A second semiconductor layer (the second semiconductor portion) 331 includes the multiple first semiconductor regions 330a. The multiple first semiconductor regions 330a are provided on the first semiconductor layer 20. The multiple first semiconductor regions 330a each extend in a Y-axis direction on the first semiconductor layer 20. The multiple first semiconductor regions 330a are disposed apart from each other in an X-axis direction. In this example, the multiple first semiconductor regions 330a are disposed at substantially equal intervals in the X-axis direction.

The second semiconductor layer 331 includes the multiple fifth semiconductor regions 330b. The multiple fifth semiconductor regions 330b are provided on the first semiconductor layer 20. The multiple fifth semiconductor regions 330b each extend in the X-axis direction on the first semiconductor layer 20. The multiple fifth semiconductor regions 330b are disposed apart from each other in the Y-axis direction. In this example, the multiple fifth semiconductor regions 330b are disposed at substantially equal intervals in the Y-axis direction. That is, the first semiconductor region 330a and the fifth semiconductor region 330b are disposed so as to intersect each other on the XY plane to form a lattice shape.

As described with reference to FIG. 1, the XY plane is parallel to the first face 11a or the second face 11b of the semiconductor substrate 10, and the [11-20] axis of the semiconductor substrate 10 is inclined by the off angle $\theta$off with respect to the X axis about the Y axis. The [0001] axis of the semiconductor substrate 10 is inclined by the off angle $\theta$off with respect to the Z axis about the Y axis. The Y axis is parallel to the [1-100] axis orthogonal to the {1-100} plane of the semiconductor substrate 10. That is, the multiple first semiconductor regions 330a each extend along the [1-100] axis of the semiconductor substrate 10. The multiple first semiconductor regions 330a are disposed apart from each other at substantially equal intervals with respect to the [11-20] axis of the semiconductor substrate 10. The multiple fifth semiconductor regions 330b each extend along the [11-20] axis of the semiconductor substrate 10. The multiple fifth semiconductor regions 330b are disposed apart from each other at substantially equal intervals with respect to the [1-100] axis of the semiconductor substrate 10.

The sixth semiconductor layer 340 is provided on the multiple first semiconductor regions 330a and the multiple fifth semiconductor regions 330b. The sixth semiconductor layer 340 includes a second semiconductor region 342, and the second semiconductor region 342 is provided on the first semiconductor layer 20. The second semiconductor region 342 of the sixth semiconductor layer 340 is surrounded by two adjacently facing first semiconductor regions 330a and two adjacently facing fifth semiconductor regions 330b on the first semiconductor layer 20.

The semiconductor substrate 10, the first semiconductor layer 20, the multiple first semiconductor regions 330a, the multiple fifth semiconductor regions 330b, the sixth semiconductor layer 340, and the second semiconductor region 342 contain first conductivity type impurities. The first conductivity type is, for example, n type.

Similar to the second semiconductor layer 30 of the semiconductor device 1 shown in FIG. 1, the first semiconductor region 330a and the fifth semiconductor region 330b contain SiC and the first element as an impurity. The first element includes at least one selected from the group containing of N, P, Al, and B. Similar to the semiconductor device 1, the first semiconductor region 330a and the fifth semiconductor region 330b may contain the second element instead of the first element or together with the first element. The second element includes at least one selected from the group containing of Fe, Ni, Cr, Mg, Zn, Cu, Ca, V, Au, and Pt.

The multiple first semiconductor regions 330a and the multiple fifth semiconductor regions 330b have the same impurity concentration. The impurity concentration in the first semiconductor region 330a and the fifth semiconductor region 330b is the same as or lower than an impurity concentration in the first semiconductor layer 20. The impurity concentration in the first semiconductor region 330a and the fifth semiconductor region 330b is the same as or higher than an impurity concentration in the sixth semiconductor layer 340 and the second semiconductor region 342.

The multiple first semiconductor regions 330a and the multiple fifth semiconductor regions 330b have the same point defect density. The point defect density of the first semiconductor region 330a and the fifth semiconductor region 330b is the same as or higher than a point defect density of the first semiconductor layer 20. The point defect density of the first semiconductor region 330a, the point defect density of the fifth semiconductor region 330b, and the point defect density of the first semiconductor layer 20 are higher than both a point defect density of the semiconductor substrate 10 and a point defect density of the sixth semiconductor layer 340 and the second semiconductor region 342.

A relationship between a distance between the adjacent first semiconductor regions 330a and a thickness of the first semiconductor region 330a may be the same as that in the example shown in FIG. 22 from the viewpoint of preventing the expansion of the 1SSF.

The semiconductor device 301 according to the embodiment can be manufactured in the same manner as the semiconductor device 201 shown in FIG. 20. That is, by setting the aperture AP of the mask M1 shown in FIG. 23 at a position corresponding to the first semiconductor region 330a and the fifth semiconductor region 330b intersecting in a grid pattern, the first semiconductor region 330a and the second semiconductor region 330b can be formed.

An operation of the semiconductor device 301 according to the embodiment will be described.

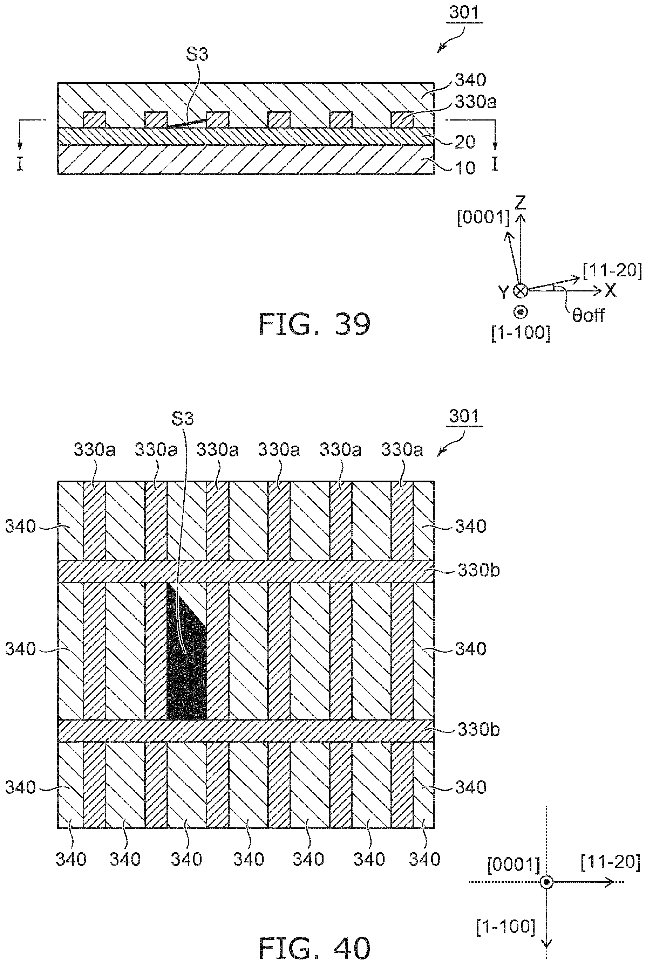

FIG. 39 is a schematic cross-sectional view describing the operation of the semiconductor device according to the third embodiment.

FIG. 40 is a schematic cross-sectional view taken along a line I-I in FIG. 39.

As shown in FIG. 39 and FIG. 40, in the semiconductor device 301 according to the embodiment, the sixth semiconductor layer 340 has a portion provided on the first semiconductor layer 20. In this portion, the BPD generated in the first semiconductor layer or the semiconductor substrate 10 can obtain recombination energy of minority carriers and expand to a defect S3 which is the 1SSF. The defect S3 expands upward at the off angle θoff with respect to the XY plane about the Y axis.

The 1SSF is known to expand in a triangular shape as shown in FIG. 26 and FIG. 28, as well as in a bar shape. The bar-shaped defect S3 makes the {0001} plane of SiC expand toward both a [1-100]-axis direction and a [1100]-axis direction. Therefore, in the semiconductor region 230 of the semiconductor device 201 shown in FIG. 20, expansion in a [11-20]-axis direction may be prevented, but expansion in the [1-100]-axis direction and the [1100]-axis direction may not be prevented. In the semiconductor device 301 according to the embodiment, the first semiconductor region 330a and the fifth semiconductor region 330b are made to intersect each other, and the expansion of the bar-shaped defect is prevented by the first semiconductor region 330a and the fifth semiconductor region 330b.

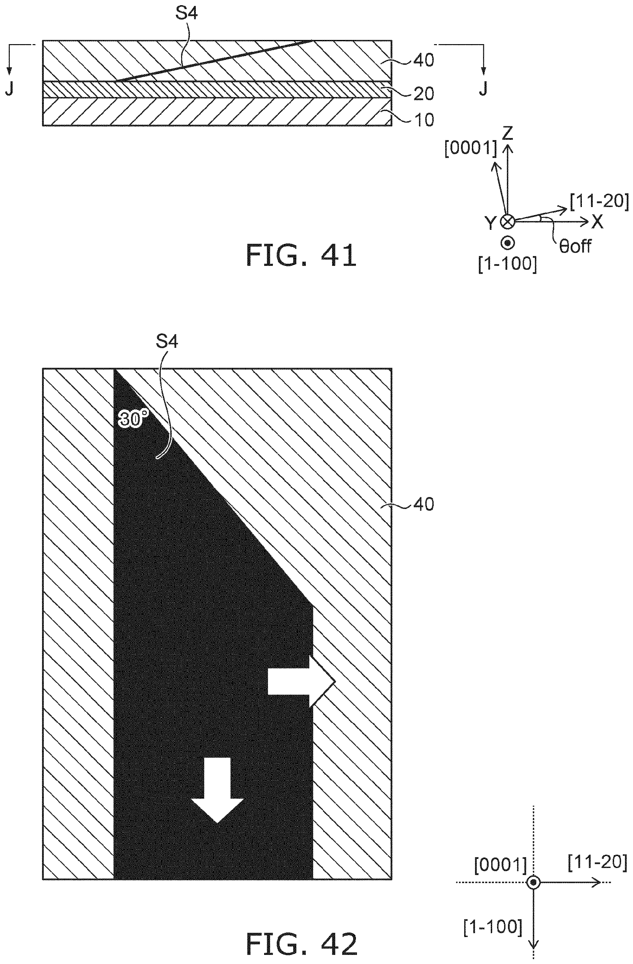

FIG. 41 is a schematic cross-sectional view describing an operation of a semiconductor device according to a comparative example.

FIG. 42 is a schematic cross-sectional view taken along a line J-J in FIG. 41.

A configuration of the semiconductor device of the comparative example in FIG. 41 and FIG. 42 is the same as the configuration of the semiconductor device shown in FIG. 27 and FIG. 28. That is, as shown in FIG. 41 and FIG. 42, in the semiconductor device according to the comparative example, the first semiconductor region 330a and the fifth semiconductor region 330b are not provided, and the sixth semiconductor layer 240c is provided on the first semiconductor layer 20.

In the semiconductor device of the comparative example, the minority carriers supplied to the sixth semiconductor layer 240c are recombined in the sixth semiconductor layer 240c and continue to supply the recombination energy to a defect S4 which is the 1SSF. As long as the recombination energy is supplied, the defect S4 continues to spread in the third semiconductor layer 40 in a planar shape having a triangular outer shape, and can reach an interface with the fourth semiconductor layer 50. The planar defect S4 spreads along the {0001} plane of SiC of the sixth semiconductor layer 240c, and thus the defect S4 is formed substantially orthogonal to a current path. Therefore, conduction of the semiconductor device is inhibited, and an operating voltage increases.

As described above, in the semiconductor device 301 according to the embodiment, the first semiconductor region 330a and the fifth semiconductor region 330b intersecting with each other in a lattice shape can stop the expansion of the 1SSF in any mode, and prevent an increase in loss during conduction of the semiconductor device 301.

In the semiconductor device 301 according to the embodiment, the variation of the second embodiment described with reference to FIG. 29 and FIG. 33 can be applied to the first semiconductor region and the fifth semiconductor region, and the same effect can be obtained.

In each of the embodiments and the variations described above, the semiconductor device is mainly a PiN diode. The semiconductor device is not limited to the PiN diode as long as the semiconductor device has a PiN structure in which a second conductivity type semiconductor layer is joined to a first conductivity type semiconductor layer with a low impurity concentration. For example, a MOSFET having a DMOS structure may be applied as the semiconductor device of each of the embodiments and the variations.

In this way, a semiconductor device having stable characteristics can be implemented.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

**Claims**

1. A semiconductor device (1) comprising:

   a semiconductor substrate (10) of a first conductivity type, the semiconductor substrate containing silicon carbide and having a first face (11a) and a second face (11b) opposite to the first face;
   a first semiconductor portion (20) of the first conductivity type, the first semiconductor being provided on the first face and containing silicon carbide;
   a second semiconductor portion (30) of the first conductivity type, the second semiconductor portion being provided on the first semiconductor portion and containing silicon carbide;
   a third semiconductor portion (40) of the first conductivity type, the third semiconductor portion being provided on the second semiconductor portion and containing silicon carbide; and
   a fourth semiconductor portion (50) of a second conductivity type, the fourth semiconductor portion being provided on the third semiconductor portion and containing silicon carbide,
   a carrier concentration of the first conductivity type in the second semiconductor portion being the same as or lower than a carrier concentration of the first conductivity type in the first semiconductor portion,
   the carrier concentration of the first conductivity type in the second semiconductor portion being the same as or higher than a carrier concentration of the first conductivity type in the third semiconductor portion, and
   a point defect density in the second semiconductor portion being the same as or higher than a point defect density in the first semiconductor portion, and being higher than a point defect density in the third semiconductor portion.

2. The semiconductor device according to claim 1, further comprising:

   a fifth semiconductor portion (42) of the first conductivity type, the fifth semiconductor portion being provided between the first semiconductor portion and the second semiconductor portion and containing silicon carbide,
   the carrier concentration of the first conductivity type in the second semiconductor portion being the same as or higher than a carrier concentration of the first conductivity type in the fifth semiconductor portion, and
   the point defect density in the second semiconductor portion being higher than a point defect density in the fifth semiconductor portion.

3. The semiconductor device according to claims 1 or 2, wherein

   the second semiconductor portion includes a first layer (32) provided on the first semiconductor portion and a second layer (34) provided on the first layer,
   a carrier concentration of the first conductivity type in the first layer is the same as or lower than the carrier concentration of the first conductivity type in the first semiconductor portion,
   a carrier concentration of the first conductivity type in the second layer is the same as or lower than the carrier concentration of the first conductivity type in the first layer, and is the same as or higher than the carrier concentration of the first conductivity type in the third semiconductor portion, and
   a point defect density in the first layer and a point defect density in the second layer are the same as or higher than the point defect density in the first semiconductor portion, and are higher than the point defect density in the third semiconductor portion.

4. The semiconductor device according to claim 1, wherein

the second semiconductor portion (231) includes a plurality of first portions (230),
the third semiconductor portion includes a second portion provided on the first semiconductor portion,
the second portion is provided between two adjacent first portions among the plurality of first portions,
the first face is parallel to a plane including a first direction (X) and a second direction (Y) intersecting the first direction,
the plurality of first portions extend along the first direction and are spaced apart along the second direction,
a {0001} plane of silicon carbide forms a first angle ($\theta$off) with the first face about a [1-100] axis orthogonal to a {1-100} plane of silicon carbide, and
the second direction is parallel to a direction along which the [1-100] axis extends.

**5.** The semiconductor device according to claim 4, wherein

the third semiconductor portion (240d) includes a third portion (243) provided on the first semiconductor portion, and
the third portion is provided between the first semiconductor portion and at least one of the two first portions.

**6.** The semiconductor device according to claims 4 or 5, wherein

the first semiconductor portion (220) includes a fourth portion (224),
the fourth portion is provided between the two first portions, and
the second portion (242b) is provided on the fourth portion.

**7.** The semiconductor device according to claim 4, wherein

the second semiconductor portion (331) includes a plurality of fifth portions (330a),
the plurality of fifth portions extend along the second direction and are spaced apart along the first direction, and
the second portion is surrounded by the two first portions and two fifth portions among the plurality of fifth portions on the first semiconductor portion.

**8.** The semiconductor device according to any one of claims 4 to 7, wherein

a distance between the two first portions is set based on a thickness of the plurality of first portions and the first angle.

**9.** The semiconductor device according to any one of claims 1 to 3, wherein

a first conductivity type carrier of the second semiconductor portion contains a first element, and
the first element includes at least one selected from the group containing of N, P, Al, and B.

**10.** The semiconductor device according to any one of claims 1 to 3, wherein

the second semiconductor portion contains a second element, and
the second element includes at least one selected from the group containing of Fe, Ni, Cr, Mg, Zn, Cu, Ca, V, Au, and Pt.

# FIG. 1

# FIG. 2

# FIG. 3

## FIG. 4

## FIG. 5

## FIG. 6

## FIG. 7

## FIG. 8

FIG. 9

FIG. 10

FIG. 11

FIG. 12

FIG. 13

FIG. 14

FIG. 15

## FIG. 16

## FIG. 17

## FIG. 18

## FIG. 19

FIG. 20

FIG. 21

FIG. 22

FIG. 23

FIG. 24

S1

240
230

D

D

20
10

Z

[0001]

[11-20]

Y ⊗ X

[1-100] θoff

# FIG. 25

S1

230 230 230 230 230 230

240 240 240 240 240 240 240

[0001] [11-20]

[1-100]

# FIG. 26

FIG. 27

FIG. 28

FIG. 29

FIG. 30

# FIG. 31

AP — — AP
M2
240e
20
10

Z
Y⊗→X

# FIG. 32

230   230aB   230
h2 ↓        240f
20
10

Z
Y⊗→X

# FIG. 33

# FIG. 34

FIG. 35

FIG. 36

301

331
330a 330a 330b

340

20
10

H

H

11a

342

Z
Y⊗→X

# FIG. 37

301

330a 330a 330a 330a 330a 330a

342                                                          342

330b

342                                                          342

330b

342                                                          342
340

342 342 342 342 342

Y
Z⊙→X

# FIG. 38

301

S3

340
330a

20
10

I

I

Z
[0001]
[11-20]
Y
X
θoff
[1-100]

# FIG. 39

S3

301

330a  330a  330a  330a  330a  330a

340                                          340

330b

340                                          340

340                                          340

330b

340                                          340

340  340  340  340  340  340  340

[0001]      [11-20]

[1-100]

# FIG. 40

FIG. 41

FIG. 42

Europäisches
Patentamt

European
Patent Office

Office européen
des brevets

# EUROPEAN SEARCH REPORT

**Application Number**

EP 23 19 5660

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/336590 A1 (KUMADA KEISHIROU [JP]) 20 October 2022 (2022-10-20) | 1,3,10 | INV. H01L29/16 |
| Y | * paragraphs [0002], [0050], [0051], | 4-6,8 | H01L29/32 |
| A | [0075]; figure 6 * | 7 | H01L21/329 H01L29/861 |
| X | US 2020/006066 A1 (KONISHI KUMIKO [JP] ET AL) 2 January 2020 (2020-01-02) * paragraphs [0139] – [0148]; figure 14 * | 1-3,9 | ADD. H01L29/78 |
| X | US 2019/296141 A1 (RUPP ROLAND [DE] ET AL) 26 September 2019 (2019-09-26) | 1 | |
| Y | * paragraphs [0079], [0087] – [0096]; | 4,6,8 | |
| A | figures 4A,4B,8B * | 7 | |
| Y | US 2020/203513 A1 (KONRATH JENS PETER [AT] ET AL) 25 June 2020 (2020-06-25) | 4-6,8 | |
| A | * paragraphs [0101], [0130]; figures 2B,2D,8,9B,10,11 * | 7 | |
| T | WANG RONG ET AL: "Impurities and defects in 4H silicon carbide", APPLIED PHYSICS LETTERS, AMERICAN INSTITUTE OF PHYSICS, 2 HUNTINGTON QUADRANGLE, MELVILLE, NY 11747, vol. 122, no. 18, 2 May 2023 (2023-05-02), XP012274362, ISSN: 0003-6951, DOI: 10.1063/5.0145350 [retrieved on 2023-05-02] * the whole document * | | **TECHNICAL FIELDS SEARCHED (IPC)**<br><br>H01L |
| A | US 2020/127083 A1 (NISHIO JOHJI [JP] ET AL) 23 April 2020 (2020-04-23) * Fig. 7 and related text * | 1-10 | |

The present search report has been drawn up for all claims

| Place of search | Date of completion of the search | Examiner |
|---|---|---|
| Munich | 20 February 2024 | Melodia, Andrea |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 5660

This annex lists the patent family members relating to the patent documents cited in the above-mentioned European search report.
The members are as contained in the European Patent Office EDP file on
The European Patent Office is in no way liable for these particulars which are merely given for the purpose of information.

20-02-2024

| Patent document cited in search report | | Publication date | Patent family member(s) | | Publication date |
|---|---|---|---|---|---|
| US 2022336590 | A1 | 20-10-2022 | JP | 2022163554 A | 26-10-2022 |
| | | | US | 2022336590 A1 | 20-10-2022 |
| US 2020006066 | A1 | 02-01-2020 | CN | 110301034 A | 01-10-2019 |
| | | | EP | 3584822 A1 | 25-12-2019 |
| | | | JP | 6791274 B2 | 25-11-2020 |
| | | | JP | WO2018150861 A1 | 14-11-2019 |
| | | | US | 2020006066 A1 | 02-01-2020 |
| | | | WO | 2018150861 A1 | 23-08-2018 |
| US 2019296141 | A1 | 26-09-2019 | CN | 110299399 A | 01-10-2019 |
| | | | DE | 102018106967 B3 | 23-05-2019 |
| | | | DE | 102019107406 A1 | 26-09-2019 |
| | | | US | 2019296141 A1 | 26-09-2019 |
| US 2020203513 | A1 | 25-06-2020 | CN | 111354796 A | 30-06-2020 |
| | | | DE | 102018133433 A1 | 25-06-2020 |
| | | | US | 2020203513 A1 | 25-06-2020 |
| US 2020127083 | A1 | 23-04-2020 | JP | 6952670 B2 | 20-10-2021 |
| | | | JP | 2020068241 A | 30-04-2020 |
| | | | US | 2020127083 A1 | 23-04-2020 |

EPO FORM P0459

For more details about this annex : see Official Journal of the European Patent Office, No. 12/82